# DEMANDE DE BREVET EUROPEEN

(11) **EP 1 568 988 A1**
(43) Date de publication de la demande: **31.08.2005**
(21) Numéro de dépôt: 05290331.7
(22) Date de dépôt: 15.02.2005
(51) Int. Cl.: G01N 21/71

(54) **Détection d'espèces gazeuses par spectroscopie d'émission optique à traitement de spectre**

(30) Priorité: 26.02.2004 FR 0450354
(71) Demandeur: ALCATEL, 75008 Paris (FR)
(72) Inventeur: Sogan, Gloria, 74330 Epagny (FR); Bounouar, Julien, 74940 Annecy-le-Vieux (FR); Desbiolles, Jean-Pierre, 74350 Cruseilles (FR); Gaurand, Isabelle, 74940 Annecy le Vieux (FR)

(57) **Abrégé**

L'invention propose un procédé de détection d'espèces gazeuses dans un mélange par spectroscopie d'émission optique, dans lequel on utilise la radiation émise par un plasma présent dans le mélange gazeux à analyser, on relève le spectre optique brut de ladite radiation émise par le plasma, et on compare le spectre optique brut à une bibliothèque de spectres optiques de référence. Selon l'invention, l'analyse du spectre optique brut comprend une étape de génération d'un spectre optique épuré, consistant à ne retenir dans le spectre optique brut que les valeurs de maximum d'amplitude et les valeurs de longueur d'onde correspondantes dans les zones adjacentes à une zone dont le taux de variation d'amplitude est supérieur à un seuil de taux déterminé. Le spectre optique épuré contient ainsi un moins grand nombre de valeurs, qu'il est plus rapide et plus facile de comparer avec des spectres optiques épurés de référence correspondant aux espèces gazeuses pures à surveiller. Il est alors possible d'assurer une surveillance d'espèces gazeuses en temps réel.

## Description

La présente invention concerne la détection d'espèces gazeuses dans un mélange par spectroscopie d'émission optique.

Pour détecter les espèces gazeuses, on a déjà eu recours à la spectroscopie d'émission optique, par laquelle on utilise la radiation lumineuse émise par un plasma présent dans un mélange gazeux à analyser, on relève le spectre optique de ladite radiation émise par le plasma, et on procède à une analyse du spectre optique pour en déduire la présence des espèces gazeuses du mélange.

La méthode classique utilisée pour l'étape d'analyse du spectre optique consiste à visualiser le spectre optique en temps réel et à le comparer aux spectres publiés dans les bibliothèques scientifiques réalisées pour chaque espèce gazeuse. La méthode repose sur le fait que chaque espèce gazeuse génère une radiation lumineuse dont le spectre est caractéristique lorsqu'elle atteint un niveau d'excitation émettant de la lumière. Les bibliothèques scientifiques contiennent ainsi les spectres d'émission optique de chaque espèce gazeuse. Ces spectres sont chacun constitués de la courbe des valeurs d'intensité lumineuse en fonction de la longueur d'onde, dans la plage des longueurs d'onde des radiations lumineuses, c'est-à-dire dans l'ultraviolet, le spectre visible, l'infrarouge. Généralement, le spectre d'émission optique d'une espèce gazeuse est une courbe d'allure ondulatoire qui présente un grand nombre de pics ou raies. Chaque raie est caractérisée par la longueur d'onde et par l'intensité de la radiation lumineuse à cette longueur d'onde.

Dans les dispositifs connus, la visualisation du spectre optique d'émission est généralement effectuée par un ordinateur qui scrute les données émises par un spectromètre optique. Un logiciel associé au spectromètre permet habituellement d'agir sur le temps d'intégration du signal issu du spectromètre, et donc sur l'intensité du spectre. Le logiciel peut agir également sur le nombre de spectres dont on effectue la moyenne avant affichage, ce qui permet de diminuer le bruit. Le logiciel permet alors de visualiser le spectre optique d'émission instantané, et de suivre l'évolution d'amplitude de certaines raies pour en déduire l'évolution de la présence d'un gaz. En effet, l'amplitude d'une raie A1 à la longueur d'onde λ1 issue d'un spectre de mesure associée à l'identification d'une espèce A permet, lorsque le gaz est seul, de suivre l'évolution de la présence de ce gaz. Le logiciel permet également d'effectuer un certain nombre d'opérations mathématiques telles que des soustractions de spectres.

Mais l'inconvénient de ces solutions traditionnelles réside dans la difficulté de l'interprétation du spectre obtenu. En effet, il est impossible de connaître immédiatement l'espèce ou les espèces contenues dans un mélange. Cela nécessite de consulter des tables de spectres connus et de chercher à reconnaître, dans le spectre à analyser, les raies des spectres connus. On identifie une première raie dans le spectre de la littérature, puis une deuxième ...

L'analyse du spectre nécessite d'être réalisée par un expert, car les difficultés sont nombreuses, et notamment :
- dans le spectre à analyser, certaines raies de l'espèce gazeuse à rechercher peuvent être absentes, bien que l'espèce gazeuse soit réellement présente ; l'absence de certaines raies peut résulter notamment des conditions de génération du plasma, car la présence de ces raies dépend de la puissance de la source et d'autres paramètres du plasma ;
- dans le spectre à analyser, du fait de la résolution nécessairement limitée du spectromètre, il est souvent difficile de connaître avec précision la longueur d'onde caractéristique d'une raie du spectre, et il est alors difficile d'attribuer cette raie à l'une ou l'autre des espèces gazeuses possibles ; cela est d'autant plus difficile en présence de raies très voisines ;
- certaines espèces gazeuses facilement excitables peuvent noyer la visualisation d'autres gaz intéressants, qui n'ont plus assez d'énergie pour atteindre des niveaux d'excitation émettant de la lumière ; il en résulte que tout ou partie des raies d'une espèce gazeuse peuvent être absentes à cause de la présence d'autres espèces gazeuses facilement excitables, et il faut en tenir compte dans l'analyse du spectre ;
- le logiciel associé au spectromètre n'est pas capable d'interpréter de façon fiable l'évolution d'amplitude de la radiation aux longueurs d'onde caractéristiques du spectre ; par exemple, en présence d'une première espèce A ayant une raie A1 à la longueur d'onde λ1, comme illustré sur la figure 3A, le logiciel va suivre l'évolution de l'amplitude à la longueur d'onde λ1 ; si l'on introduit alors en mélange une seconde espèce B ayant une raie B1 à la longueur d'onde λ2 proche de λ1, comme illustré sur la figure 3B, le logiciel va détecter une augmentation d'amplitude A1 jusqu'à A'1 et risque d'en déduire une augmentation de quantité de l'espèce A comme illustré sur la figure 3C, alors que c'est la présence de l'espèce B qui explique l'augmentation d'amplitude à la longueur d'onde λ1 ; cela montre qu'il est dangereux de suivre l'évolution d'une espèce en se basant sur l'amplitude d'une seule raie ; et le suivi de plusieurs raies est encore plus compliqué à interpréter.

L'expert doit tenir compte de toutes les difficultés ci-dessus, pour extraire du spectre obtenu l'information pertinente sur la présence des espèces gazeuses du mélange, et sur leur évolution.

Ces solutions traditionnelles nécessitent donc l'intervention permanente d'un expert pour analyser les spectres obtenus, et cette analyse est longue et fastidieuse, ce qui rend illusoire une analyse en temps réel permettant par exemple la détection de l'évolution d'un paramètre de l'équipement dans lequel circule le mélange gazeux à analyser.

Le problème proposé par la présente invention est d'éviter les inconvénients des systèmes de l'art antérieur, en permettant d'obtenir de façon automatique et rapide la composition d'un mélange gazeux étudié par spectroscopie d'émission optique, sans l'intervention d'un expert.

L'invention vise ainsi à permettre le suivi en temps réel de la composition des mélanges gazeux.

Et l'invention vise à automatiser l'interprétation des spectres obtenus par un dispositif de spectroscopie d'émission optique.

L'idée essentielle de l'invention est pour cela de traiter numériquement, et de préférence en temps réel, le spectre délivré par un spectromètre d'émission optique, pour en extraire l'information significative.

Pour cela, dans le spectre d'émission optique brut, on considère qu'une pente abrupte est significative d'une information utile pour l'analyse des espèces gazeuses. On retient donc, dans le spectre, les informations qui sont au voisinage de cette zone à pente abrupte.

Le spectre est constitué par la courbe des valeurs d'intensité de radiation lumineuse en fonction de la longueur d'onde de la radiation. En pratique, les résultats donnés par le spectromètre optique sont contenus dans une suite de tableaux, chaque tableau représentant le spectre à un instant d'échantillonnage. Chaque tableau est formé d'une suite de valeurs d'intensité et de la suite correspondante simultanée des valeurs de longueur d'onde.

On recherche les zones du tableau qui correspondent à des variations rapides de l'intensité de radiation lumineuse en fonction de la longueur d'onde. Pour chaque zone de tableau correspondant à une telle variation rapide de l'intensité de radiation lumineuse en fonction de la longueur d'onde, on retient la valeur d'intensité maximale qui est au voisinage de la zone de variation rapide d'intensité, et on retient la valeur de longueur d'onde correspondant à ce maximum d'intensité.

On définit alors un tableau de spectre optique épuré, qui contient seulement les valeurs d'intensité maximale et les valeurs de longueur d'onde correspondantes qui sont à proximité immédiate de zones où la variation d'intensité est supérieure à un seuil déterminé de variation d'intensité.

Par cette procédure, le spectre optique brut, constitué initialement de plusieurs milliers de points couvrant la plage spectrale du spectromètre, se trouve simplifié et remplacé par un spectre optique épuré contenant seulement une centaine de points caractéristiques constitués par les valeurs d'intensité maximale et de longueur d'onde correspondant à des zones de variation d'intensité supérieure au seuil déterminé.

Le seuil de variation d'intensité déterminé peut être ajusté, en fonction du degré d'épuration désiré du spectre.

Dans les mélanges gazeux habituels, un spectre optique brut est un tableau formé d'une suite de plusieurs milliers de valeurs d'intensité et de valeurs correspondantes de longueur d'onde. On comprend qu'une comparaison portant sur de tels tableaux à plusieurs milliers de valeurs est fastidieuse et longue, ce qui rend illusoire un suivi en temps réel.

Ainsi, pour atteindre ces buts ainsi que d'autres, l'invention propose un procédé de détection d'espèces gazeuses dans un mélange par spectroscopie d'émission optique, dans lequel on utilise la radiation émise par un plasma présent dans le mélange gazeux à analyser, à l'aide d'une chaîne de mesure on relève le spectre optique brut de ladite radiation émise par le plasma, et on compare le spectre optique brut à une bibliothèque de spectres optiques de référence ; le procédé comprend une étape de génération d'un spectre optique épuré, consistant à ne retenir dans le spectre optique brut que les seules zones de spectre présentant une forme significative correspondant à un critère de forme prédéfini, et on compare ensuite ledit spectre épuré à la bibliothèque de spectres optiques de référence.

Le critère de forme prédéfini est de préférence choisi de façon à réduire sensiblement le nombre de points représentatifs de l'information utile comprise dans le spectre, et ainsi le nombre des valeurs d'intensité et des valeurs de longueur d'onde correspondantes qu'il faut conserver dans un tableau représentant le spectre.

En pratique, on réalise un traitement fiable du spectre en particulier en choisissant comme critère de forme prédéfini le taux de variation de l'amplitude de la radiation lumineuse en fonction de la longueur d'onde dans le spectre optique brut.

Pour cela, on peut procéder simplement en retenant, dans le spectre optique épuré, les valeurs de maximum d'amplitude et les valeurs de longueur d'onde correspondantes dans les zones de spectre optique brut adjacentes à une zone dont le taux de variation d'amplitude est supérieur à un seuil de taux déterminé.

Il reste encore à comparer ce spectre optique épuré à des spectres optiques de référence concernant les espèces gazeuses susceptibles d'être présentes dans le mélange à analyser.

En fonction de la puissance transmise, de la pression et de la nature du mélange gazeux, une espèce va atteindre un niveau d'excitation qui va lui permettre d'émettre à une longueur d'onde bien précise. Dans les tables scientifiques, on retrouve la plupart des raies données par l'expérimentation ou définies par la mécanique quantique.

Il en résulte que les tables scientifiques de spectres d'espèces gazeuses contiennent des spectres complets, caractérisés chacun par un grand nombre d'informations dont toutes ne sont pas présentes dans les conditions de mesure réalisées par un équipement donné.

L'invention propose de mettre à profit cette observation pour simplifier également les spectres optiques de référence.

On prévoit pour cela une étape préalable d'établissement d'une bibliothèque de spectres optiques de référence, contenant au moins un spectre optique de référence pour chaque espèce gazeuse à surveiller, ledit spectre optique de référence étant réalisé par analyse spectrale de l'espèce gazeuse à surveiller au moyen de ladite chaîne de mesure que l'on veut utiliser pour la détection d'espèces gazeuses dans le mélange, et on utilise ensuite ladite bibliothèque de spectres optiques de référence pour la comparaison avec le spectre optique épuré.

L'intérêt est que la réalisation du spectre optique de référence avec ladite chaîne de mesure conduit à un spectre simplifié, qui contient un moins grand nombre de données caractéristiques que les spectres publiés dans les tables scientifiques, et le spectre de référence est adapté aux conditions de mesure pour la mise en oeuvre de l'invention. Notamment, certaines raies du spectre optique de l'espèce gazeuse considérée peuvent être absentes, cette absence résultant des conditions réelles de génération du plasma dans l'équipement contenant ladite chaîne de mesure. L'absence de ces raies ne sera ainsi pas interprétée ultérieurement comme un critère d'absence de l'espèce gazeuse considérée.

Ensuite, l'invention propose une étape d'épuration du spectre optique de référence, comme on le fait pour le spectre optique brut : au cours de cette étape, dans le spectre optique de référence épuré, on ne retient que les valeurs de maximum d'amplitude et les valeurs de longueur d'onde correspondantes des zones de spectre optique de référence adjacentes à une zone dont le taux de variation d'amplitude est supérieur à un seuil de taux déterminé dudit spectre optique de référence. Il en résulte que le spectre optique de référence épuré contient un nombre nettement réduit de valeurs caractéristiques, et il lui correspond un tableau de données de taille grandement réduit.

On comprend qu'il est alors plus facile et plus rapide d'effectuer la comparaison du spectre optique épuré et des spectres optiques de référence épurés.

L'invention propose ensuite d'extraire du spectre optique épuré la partie de spectre correspondant à une espèce gazeuse à surveiller, puis de calculer la valeur moyenne d'intensité du spectre optique épuré de ladite espèce gazeuse. On peut ensuite relever et mémoriser, ou afficher, son évolution temporelle.

Grâce à sa rapidité, le procédé de détection d'espèces gazeuses peut trouver des applications nombreuses mettant en oeuvre la détection d'espèces gazeuses en temps réel, et la génération de signaux d'alerte ou de commande en fonction de l'évolution de ces espèces gazeuses.

Selon un autre aspect, l'invention propose un dispositif pour la mise en oeuvre d'un procédé tel que défini ci-dessus. Un tel dispositif comprend une source de plasma pour générer un plasma dans le mélange gazeux à étudier, des moyens pour recueillir et transmettre à un spectromètre optique la radiation émise par le plasma, un ordinateur pour analyser les signaux émis par le spectromètre optique, l'ordinateur comportant une unité centrale et un programme enregistré dans une mémoire de programme, ledit programme comportant la suite d'instructions mettant en oeuvre ledit procédé.

De préférence, la mémoire de l'ordinateur contient une zone de bibliothèque contenant les spectres optiques de référence des espèces gazeuses à analyser.

D'autres objets, caractéristiques et avantages de la présente invention ressortiront de la description suivante de modes de réalisation particuliers, faite en relation avec les figures jointes, parmi lesquelles :
- la figure 1 illustre schématiquement une réalisation pratique d'un dispositif de détection d'espèces gazeuses selon la présente invention ;
- la figure 2 illustre un spectre d'émission optique tel que celui que peut donner un spectromètre d'émission optique dans l'analyse d'un mélange gazeux pris à titre d'exemple ;
- les figures 3A, 3B et 3C illustrent la difficulté d'interprétation d'un spectre de mélange à l'aide des logiciels connus associés aux spectromètres ;
- la figure 4 illustre l'allure du spectre optique épuré obtenu, à partir du spectre de la figure 2, par un procédé selon l'invention en retenant un premier seuil de taux de variation d'amplitude ;
- la figure 5 illustre l'allure du spectre optique épuré obtenu, à partir du spectre de la figure 2, par un procédé selon l'invention en retenant un second seuil plus bas de taux de variation d'amplitude ;
- les figures 6A, 6B et 6C illustrent respectivement un autre spectre d'émission optique et les spectres optiques épurés obtenus en retenant les mêmes premier et second seuils de taux de variation d'amplitude ; et
- la figure 7 illustre schématiquement la place de la chaîne de mesure dans le dispositif de la figure 1.

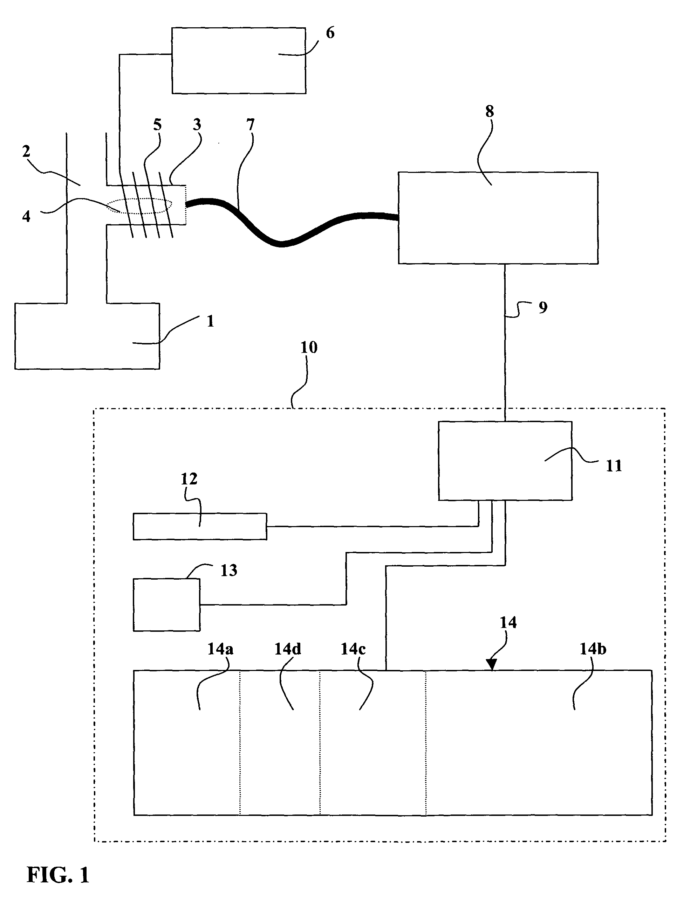

Dans le mode de réalisation illustré sur la figure 1, le dispositif de détection d'espèces gazeuses selon l'invention est associé à un équipement dans lequel circule un mélange gazeux à analyser. Un exemple d'un tel équipement comprend une chambre de procédés 1, pouvant être, de façon non limitative, une chambre de procédés utilisée dans la fabrication de semi-conducteurs, de microsystèmes électromécaniques (MEMS). Mais le dispositif peut également être appliqué à tout autre équipement dans lequel on veut analyser un mélange gazeux.

Dans le cas de la figure 1, les mélanges gazeux sortent de la chambre de procédés 1 par une canalisation de vide 2.

Dans la canalisation de vide 2, ou dans une enceinte d'excitation dérivée 3, ou encore dans la chambre de procédés 1, se trouve une zone dans laquelle le mélange gazeux est excité en formant un plasma 4. Par exemple, dans l'enceinte d'excitation dérivée 3, on a réalisé un plasma 4 par excitation électromagnétique au moyen d'une antenne d'excitation 5 alimentée par un générateur de puissance 6. Un autre exemple consiste à utiliser un générateur micro-ondes, à la place de l'antenne d'excitation 5 alimentée par le générateur de puissance 6.

La radiation lumineuse émise par le plasma 4 est captée et transmise jusqu'à un spectromètre optique 8. La transmission peut être assurée par une fibre optique 7, ou par un connecteur adapté, ou par tout autre moyen de transmission de lumière.

Le spectromètre optique 8 génère de façon connue les signaux image du spectre optique détecté, et les envoie par une ligne 9 à un ordinateur 10.

L'ordinateur 10, schématiquement illustré, comprend une unité centrale 11 connectée à des moyens d'entrée-sortie 12 tels qu'un clavier, connectée à des moyens de visualisation 13 tels qu'un écran, et connectée à une mémoire 14.

La mémoire 14 contient une zone de programmes 14a dans laquelle sont enregistrés des programmes.

La mémoire 14 contient également une zone de bibliothèque 14b, susceptible de contenir des données de référence.

La mémoire 14 contient une zone de mémoire de mesure 14c, dans laquelle peuvent être enregistrées les données des spectres optiques bruts reçus du spectromètre optique 8.

La mémoire 14 contient une zone de mémoire de résultats 14d pouvant contenir les données des spectres optiques épurés obtenus par le traitement des spectres optiques bruts selon le procédé de l'invention.

La zone de programmes 14a contient notamment un programme d'épuration de spectre selon le procédé de l'invention.

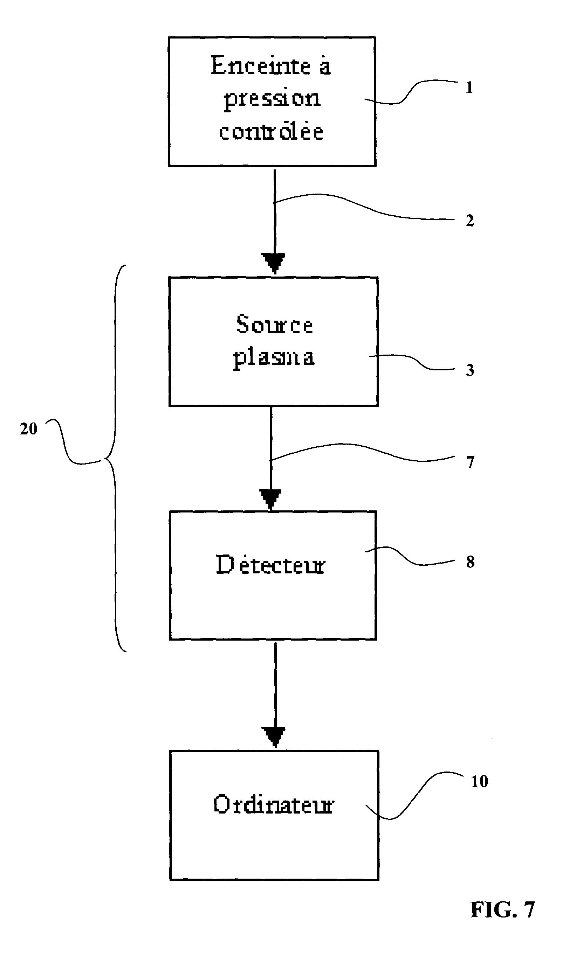

Les éléments essentiels du dispositif sont schématiquement repris sur la figure 7, dans laquelle on a repéré la chaîne de mesure 20 constituée par la combinaison de la source de plasma 3 et du détecteur optique 8 tel qu'un spectromètre optique.

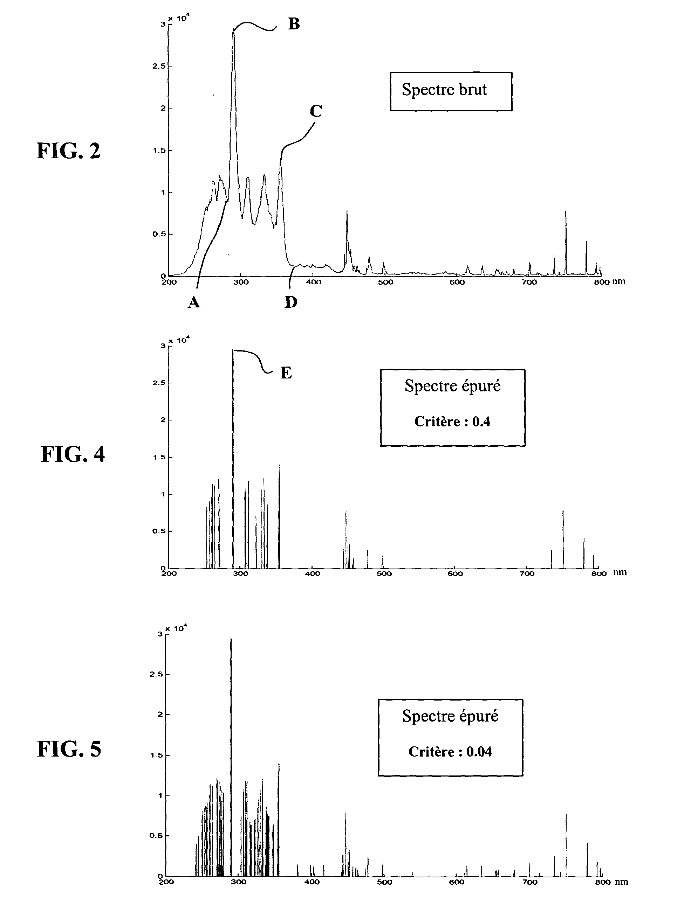

Considérons maintenant le spectre optique illustré sur la figure 2 à titre d'exemple. Il s'agit de la courbe d'intensité lumineuse, en ordonnées, en fonction des longueurs d'onde en abscisses. On voit que cette courbe, correspondant par exemple à un mélange gazeux donné, comprend un grand nombre de pics ou de raies, c'est-à-dire de zones formant un maximum, et un même nombre de zones correspondant à un minimum, certaines raies étant très abruptes, d'autres ayant une pente plus douce.

On considère par exemple la portion de courbe allant du point A au point B. Dans cette portion de courbe, le taux de variation de l'intensité lumineuse en fonction de la longueur d'onde est très élevé, car la pente de la courbe est très grande, la courbe étant presque verticale.

Par contre, dans la zone située entre les points C et D, le taux de variation de l'intensité en fonction de la longueur d'onde est plus faible que dans la zone des points A à B.

C'est ainsi que l'on peut définir, dans la courbe illustrée sur la figure 2, des zones à fort taux de variation d'intensité en fonction de la longueur d'onde, et des zones à plus faible taux de variation d'intensité en fonction de la longueur d'onde.

Si, dans le spectre de la figure 2, on considère essentiellement les pics ayant une grande amplitude, on peut réaliser un spectre simplifié contenant seulement les valeurs d'amplitude et les valeurs de longueur d'onde correspondantes de ces pics de grande amplitude. Mais un tel spectre simplifié ne permet pas ensuite de faire une comparaison fiable avec des spectres d'espèces gazeuses pures, et l'on constate des risques d'erreurs importants.

L'invention évite ces risques d'erreurs en utilisant une autre méthode d'épuration de spectre.

Selon l'invention, on considère que l'information pertinente du spectre réside dans les zones dans lesquelles le taux de variation de l'intensité lumineuse par rapport à la longueur d'onde est supérieur à un seuil déterminé.

Ainsi, on va retenir dans le spectre de la figure 2 les informations d'intensité lumineuse et de longueur d'onde qui sont au voisinage de zones de la courbe présentant une pente supérieure à un seuil déterminé.

Il en résulte alors un spectre épuré dont l'allure est illustrée à titre d'exemple sur les figures 4 ou 5.

Le spectre épuré est constitué d'une suite d'impulsions ou de traits verticaux disjoints, dont la hauteur correspond à l'intensité du sommet de la zone considérée dans le spectre brut de la figure 2. Par exemple, on retrouve une impulsion E qui correspond à la raie dont le sommet B est visible sur la figure 2. L'impulsion E a pour valeur l'intensité lumineuse du sommet B, et se situe à la longueur d'onde du sommet B.

On voit que le spectre épuré de la figure 4 contient encore les informations des raies à grande amplitude du spectre brut original de la figure 2, par exemple l'information de la raie de sommet B.

Mais on voit que le spectre épuré de la figure 4 contient également quelques informations sur les raies de faible amplitude qui se trouvent par exemple à 500 ou 735 nanomètres de longueur d'onde.

Le spectre épuré permet ensuite une analyse fiable, par comparaison au spectre de référence des espèces gazeuses pures.

On va maintenant illustrer la façon par laquelle l'homme du métier peut choisir le taux de variation d'amplitude de radiation lumineuse en fonction de la longueur d'onde pour obtenir un spectre épuré suffisamment simple mais contenant l'information essentielle du spectre brut.

Comme on l'a déjà vu, le spectre brut de la figure 2 peut être transformé en un spectre épuré illustré sur la figure 4 en appliquant un critère de forme, à savoir une valeur de taux de variation d'amplitude de radiation lumineuse en fonction de la longueur d'onde, ayant une première valeur. Le critère correspond à la pente du pic : plus le critère est grand, plus la pente est importante. L'unité du critère est une unité d'intensité lumineuse par unité de longueur d'onde (nm). L'unité d'amplitude lumineuse est liée au capteur optique utilisé, et est une unité arbitraire.

Le choix de la valeur du critère à retenir dépend de la forme du spectre. La valeur du critère sera plus faible pour un spectre déjà bien défini par des pics à l'allure de diracs.

Ainsi, les figures 4 et 5 montrent, respectivement pour un critère de 0,4 et un critère de 0,04, l'épuration du spectre de la figure 2. On remarque, sur la figure 5 réalisée par le critère de plus petite valeur, que le nombre de raies caractéristiques est plus grand que sur la figure 4 réalisée par le critère de plus forte valeur. On peut alors considérer que l'épuration d'un spectre de la forme de celui de la figure 2 peut se faire avantageusement avec un critère de valeur relativement faible, par exemple 0,04, afin de ne pas perdre trop d'informations.

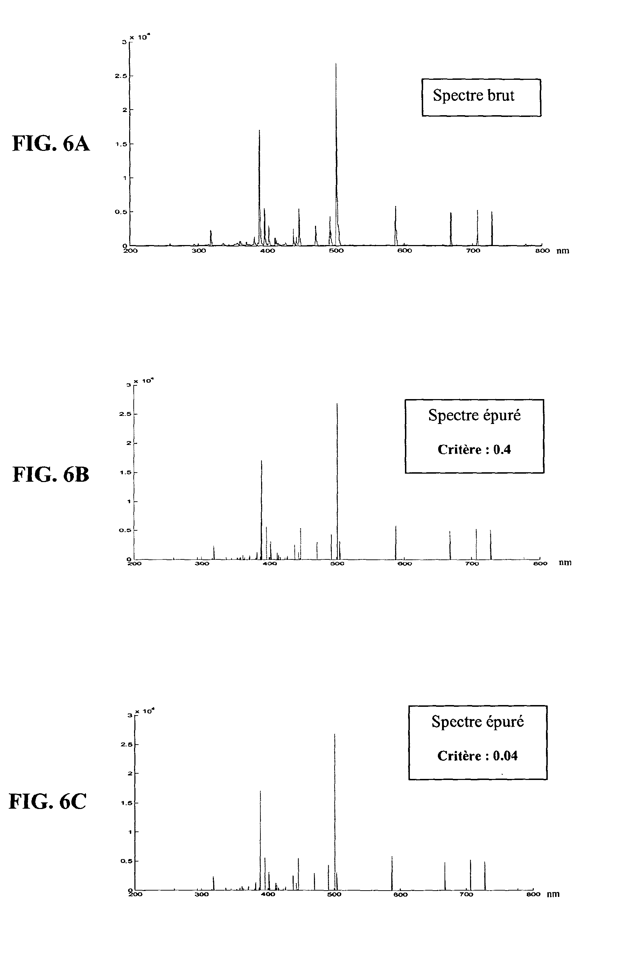

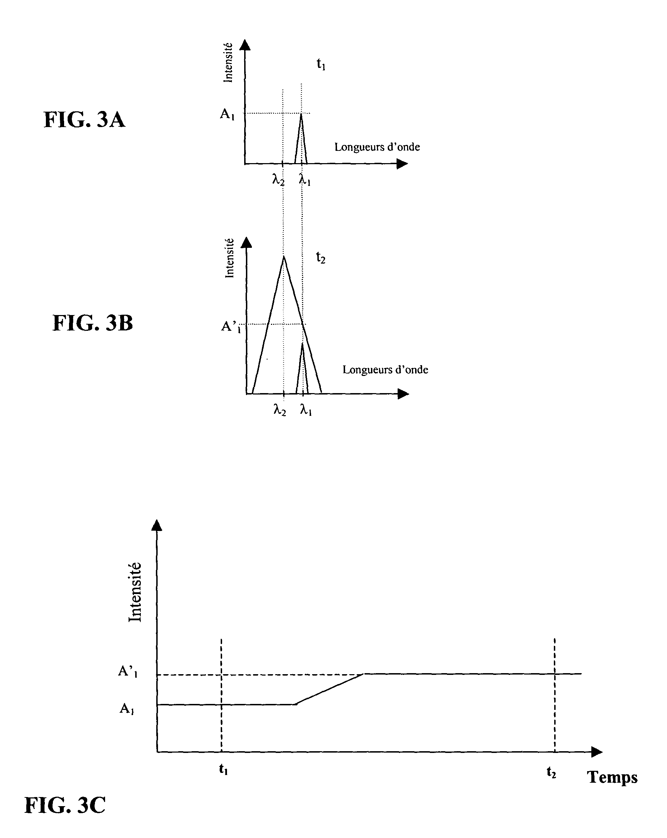

Considérons maintenant les spectres des figures 6A, 6B et 6C. Les figures 6B et 6C illustrent deux spectres épurés avec des critères respectivement de 0,4 et 0,04 à partir du spectre brut de la figure 6A. Dans ce cas, on remarque que les spectres épurés des figures 6B et 6C sont sensiblement identiques, et que le spectre de la figure 6A est déjà formé de pics très acérés sous forme de diracs. Cela montre qu'un spectre du type de celui de la figure 6A peut être épuré en utilisant un critère de valeur relativement élevée, par exemple 0,4 comme sur la figure 6B, et qu'il n'est pas nécessaire de retenir un critère de valeur plus faible, l'épuration étant déjà suffisante avec le critère 0,4.

Selon l'invention, on facilite considérablement l'analyse d'un spectre optique brut de la figure 2 en le remplaçant par un spectre optique épuré selon la figure 4, qui contient un plus faible nombre de points, et qui peut donc être traduit en un tableau de valeurs de plus faible taille.

Ensuite, selon l'invention, on peut également accélérer sensiblement l'analyse du spectre optique en simplifiant et en épurant les spectres optiques de référence de chaque espèce gazeuse pure que l'on peut retrouver dans le mélange.

Pour cela, l'invention propose de réaliser, par une méthode d'apprentissage préalable au moyen de la chaîne de mesure 20 à utiliser, une bibliothèque interne de spectres de référence. Des spectres de référence peuvent correspondre à chaque espèce gazeuse pure que l'on désire détecter et suivre dans les mélanges à analyser. D'autres spectres de référence peuvent correspondre à des mélanges d'espèces que l'on désire suivre.

On réalise ainsi une bibliothèque de spectres de référence qui est adaptée à chaque couple spectromètre-source optique constituant la chaîne de mesure 20.

Pour cela, au cours d'étapes préalables, on fait passer, dans la chaîne de mesure 20 que l'on veut utiliser, un flux gazeux contenant le gaz pur à analyser, et on mémorise le spectre de référence correspondant. Ce spectre contient la répartition énergétique des raies caractéristiques de l'espèce gazeuse dans les conditions dans lesquelles on fera ensuite la détection de la même espèce gazeuse dans le mélange à analyser. La bibliothèque de spectres pourra ainsi servir de base de données.

On notera que cette base de données contient, pour chaque espèce gazeuse, les seules raies susceptibles d'apparaître dans la chaîne de mesure 20 réellement utilisée. Il en résulte déjà, par rapport aux tables scientifiques, une réduction sensible du volume des informations à comparer lors de l'analyse du spectre optique brut obtenu du mélange gazeux à analyser.

Ensuite, selon l'invention, on procède à une étape d'épuration du spectre de chaque espèce gazeuse, de façon à réduire encore les informations contenues dans la base de données, et de façon à accélérer encore la comparaison ultérieure de ces informations avec celles du spectre optique épuré obtenu du mélange gazeux à analyser.

Lors de la confrontation du spectre optique épuré avec la bibliothèque de spectres optiques de référence épurés ainsi réalisée, un certain nombre des raies de l'espèce gazeuse recherchée vont être retrouvées. En fonction du nombre de raies retrouvées dans le spectre à analyser, pouvant être évalué en pourcentage par rapport aux raies caractéristiques du gaz telles qu'entrées dans la base de données, le logiciel va déterminer la présence d'un gaz. La pertinence du résultat va être déterminée par exemple par le pourcentage de raies retrouvées. Le critère peut être modifié par l'utilisateur.

Grâce à la possibilité d'une analyse en temps réel, résultant de la grande vitesse de comparaison possible des spectres épurés, l'invention permet aussi un suivi en temps réel de la présence d'une espèce gazeuse dans un mélange.

Pour cela, le logiciel peut calculer l'intensité moyenne de l'émission spectrale relative à une espèce gazeuse donnée, c'est-à-dire la valeur moyenne de l'intensité des raies de l'espèce gazeuse en question dans le spectre épuré. Il est alors possible d'afficher l'évolution de la seule espèce détectée, ce qui évite les mauvaises interprétations pour les espèces difficilement observables.

On comprendra que le procédé selon l'invention, consistant notamment dans l'épuration des spectres, et dans la simplification de la bibliothèque de spectres, facilite considérablement l'analyse des spectres obtenus, et permet d'automatiser cette analyse et de l'accélérer suffisamment pour permettre l'analyse en temps réel, et le suivi en temps réel d'évolution des espèces gazeuses d'un mélange.

Grâce à cette rapidité, le suivi permet de déceler un éventuel changement par rapport à un état normal préalablement déterminé par un traitement statistique sur une population de mesures.

Egalement, on peut appliquer la mesure à plusieurs équipements ayant des fonctionnements similaires, et effectuer des comparaisons afin de détecter d'éventuels défauts sur certains équipements.

Pour cela, on crée tout d'abord une référence sur un équipement. Les signatures ainsi obtenues vont permettre de comparer les différents équipements, et ainsi de déceler si l'un des paramètres d'un équipement a évolué.

Cette méthode peut s'avérer particulièrement utile après une intervention sur un équipement, lors d'une remise en production par exemple. Ces données peuvent également être associées à d'autres données provenant de l'équipement. L'objectif est d'obtenir une population de données de référence de l'équipement.

Ensuite, le suivi de l'équipement en temps réel va permettre la détection de défaut par traitement statistique. L'origine du défaut peut alors être interprétée en fonction des signatures préalablement répertoriées des défauts apparus.

L'intérêt de l'invention est alors de permettre de fournir des informations sur ce qui se passe réellement à l'intérieur d'un équipement, par exemple à l'intérieur d'une chambre de procédés, contrairement aux informations disponibles depuis l'équipement lui-même. On peut alors affiner la signature de l'équipement grâce à ces nouvelles données in situ.

En pratique, l'invention peut trouver des applications multiples.

Selon un premier exemple, on peut surveiller l'état de fonctionnement normal d'un équipement dans lequel circule le mélange gazeux analysé. Pour cela, on sélectionne les espèces gazeuses détectées qui sont représentatives de cet état de fonctionnement normal de l'équipement. On suit en temps réel l'évolution desdites espèces gazeuses sélectionnées, on compare cette évolution avec des données d'évolution de référence, et on génère un signal d'alerte ou de commande en cas de divergence par rapport aux données d'évolution de référence. Un exemple est le contrôle des propriétés d'étanchéité de l'équipement. En ce qui concerne l'étanchéité vis-à-vis de l'atmosphère extérieure, on peut rechercher la présence d'humidité dans l'équipement. En ce qui concerne l'étanchéité entre plusieurs chambres, susceptible de produire une contamination transversale, on peut rechercher toute espèce susceptible de transiter d'une chambre à l'autre, selon les procédés utilisés.

Selon un second exemple, le procédé de l'invention s'applique au contrôle d'un procédé mis en oeuvre dans l'équipement, par exemple pour détecter et/ou commander la fin d'un procédé. Pour cela, on sélectionne les espèces gazeuses détectées qui sont représentatives de l'état de progrès du procédé mettant en oeuvre le mélange gazeux analysé ; on suit en temps réel l'évolution desdites espèces gazeuses sélectionnées, on compare cette évolution avec des données d'évolution de référence du procédé, et on génère un signal d'alerte ou de commande en cas de divergence par rapport aux données d'évolution de référence du procédé. Un exemple peut être la commande de fin de gravure de tranches de semi-conducteur par un procédé de gravure au fluor. On sélectionne et on suit l'évolution de l'amplitude d'une raie appropriée du fluor, pour interrompre la gravure lorsque l'amplitude atteint un seuil au-delà duquel la gravure serait excessive. Les essais ont en effet montré que l'amplitude des raies du fluor est représentative de l'état de progrès de la gravure, et que cette amplitude augmente régulièrement pendant la gravure.

Selon un autre exemple, le procédé de mesure de l'invention s'applique à la surveillance de l'efficacité d'une purge d'enceinte par des gaz de purge. Pour cela, on sélectionne les espèces gazeuses détectées qui sont représentatives de l'état de progrès d'une purge ; on suit en temps réel l'évolution desdites espèces gazeuses sélectionnées, on compare cette évolution avec des données d'évolution de référence de la purge, et on génère un signal d'alerte ou de commande lorsqu'est atteint un état des données d'évolution de purge indiquant la fin de purge, par exemple un seuil correspondant à une fin de purge. Par exemple, on peut surveiller la purge d'un four pour réaliser un dépôt d'oxyde par un procédé LPCVD qui utilise un précurseur TEOS (C₈ H₂₀ O₄ Si). On cherche alors dans l'azote des traces de Si, O, CO, CN, H, cette liste n'étant pas exhaustive.

Selon un autre exemple, le procédé de détection de l'invention s'applique au contrôle de pureté d'un gaz. Dans ce cas, le mélange gazeux est un gaz dont on cherche à contrôler la pureté. On compare par exemple la valeur moyenne de l'amplitude des raies du spectre épuré correspondant au gaz à contrôler avec la valeur moyenne de l'amplitude des raies du spectre épuré des autres espèces gazeuses présentes dans le mélange, et on déduit de cette comparaison le degré de pureté du gaz.

Selon un autre exemple, le procédé de détection d'espèces gazeuses selon l'invention s'applique à la détection de fin de reconditionnement d'une chambre. Dans ce cas, on sélectionne les espèces gazeuses qui sont représentatives de l'état de reconditionnement d'une chambre en cours de reconditionnement ; on suit en temps réel l'évolution desdites espèces gazeuses sélectionnées dans ladite chambre en cours de reconditionnement, on compare cette évolution avec un seuil donné ou avec des données d'évolution de référence de reconditionnement de chambre, et on génère un signal d'alerte ou de commande lorsqu'est atteint un état des données desdites espèces gazeuses sélectionnées indiquant la fin de reconditionnement de chambre, par exemple lorsqu'un seuil prédéterminé est atteint.

Par exemple, dans le reconditionnement d'enceintes de chambres de procédés dans la technologie de fabrication de semi-conducteurs, on peut détecter les espèces intéressantes, à savoir le chlore ou le fluor, et l'on considère que le reconditionnement de la chambre est réalisé lorsque le niveau de présence de chlore et de fluor devient stable. Un tel procédé de détection permet d'accélérer sensiblement la procédure de reconditionnement, et évite de prolonger inutilement les étapes de reconditionnement de chambre.

La présente invention n'est pas limitée aux modes de réalisation qui ont été explicitement décrits, mais elle en inclut les diverses variantes et généralisations qui sont à la portée de l'homme du métier.

## Revendications

1. Procédé de détection d'espèces gazeuses dans un mélange par spectroscopie d'émission optique, dans lequel on utilise la radiation émise par un plasma (4) présent dans le mélange gazeux à analyser, on relève à l'aide d'une chaîne de mesure (20) le spectre optique brut de ladite radiation émise par le plasma (4), et on compare le spectre optique brut à une bibliothèque de spectres optiques de référence, **caractérisé en ce qu'**il comprend une étape de génération d'un spectre optique épuré, consistant à ne retenir dans le spectre optique brut que les seules zones de spectre présentant une forme significative correspondant à un critère de forme prédéfini, et on compare ensuite ledit spectre épuré à la bibliothèque de spectres optiques de référence.

2. Procédé selon la revendication 1, **caractérisé en ce que** le critère de forme prédéfini est le taux de variation de l'amplitude de la radiation lumineuse en fonction de la longueur d'onde dans le spectre optique brut.

3. Procédé selon la revendication 2, **caractérisé en ce qu'**on retient, dans le spectre optique épuré, les valeurs de maximum d'amplitude et les valeurs de longueur d'onde correspondantes dans les zones de spectre optique brut adjacentes à une zone dont le taux de variation d'amplitude est supérieur à un seuil de taux déterminé.

4. Procédé selon l'une quelconque des revendications 1 à 3, **caractérisé en ce qu'**il comprend une étape préalable d'établissement d'une bibliothèque de spectres optiques de référence, contenant au moins un spectre optique de référence pour chaque espèce gazeuse à surveiller, ledit spectre optique de référence étant réalisé par analyse spectrale de l'espèce gazeuse à surveiller au moyen de ladite chaîne de mesure (20) que l'on veut utiliser pour la détection d'espèces gazeuses dans le mélange, et on utilise ladite bibliothèque de spectres optiques de référence pour la comparaison avec le spectre optique épuré.

5. Procédé selon la revendication 4, **caractérisé en ce que** l'établissement de chaque spectre optique de référence comprend une étape d'épuration du spectre optique de référence, étape au cours de laquelle on retient, dans un spectre optique de référence épuré, les valeurs de maximum d'amplitude et les valeurs de longueur d'onde correspondantes des zones de spectre optique de référence adjacentes à une zone dont le taux de variation d'amplitude est supérieur à un seuil de taux déterminé dudit spectre optique de référence.

6. Procédé selon l'une quelconque des revendications 1 à 5, **caractérisé en ce qu'**on extrait du spectre optique épuré la partie de spectre correspondant à une espèce gazeuse à surveiller, on calcule la valeur moyenne d'intensité du spectre optique épuré de ladite espèce gazeuse, on relève et on mémorise ou on affiche son évolution temporelle.

7. Procédé selon l'une quelconque des revendications 1 à 6, **caractérisé en ce qu'**on sélectionne les espèces gazeuses détectées qui sont représentatives de l'état de fonctionnement d'un équipement dans lequel circule le mélange gazeux analysé, on suit en temps réel l'évolution desdites espèces gazeuses sélectionnées, on compare cette évolution avec des données d'évolution de référence, et on génère un signal d'alerte ou de commande en cas de divergence par rapport aux données d'évolution de référence.

8. Procédé selon l'une quelconque des revendications 1 à 6, **caractérisé en ce qu'**on sélectionne les espèces gazeuses détectées qui sont représentatives de l'état de progrès d'un procédé mettant en oeuvre le mélange gazeux analysé, on suit en temps réel l'évolution desdites espèces gazeuses sélectionnées, on compare cette évolution avec des données d'évolution de référence du procédé, et on génère un signal d'alerte ou de commande en cas de divergence par rapport aux données d'évolution de référence du procédé.

9. Procédé selon l'une quelconque des revendications 1 à 6, **caractérisé en ce qu'**on sélectionne les espèces gazeuses détectées qui sont représentatives de l'état de progrès d'une purge d'enceinte par des gaz de purge dont on effectue la détection, on suit en temps réel l'évolution desdites espèces gazeuses sélectionnées, on compare cette évolution avec des données d'évolution de référence de la purge, et on génère un signal d'alerte ou de commande lorsqu'est atteint un état des données d'évolution de purge indiquant la fin de purge.

10. Procédé selon l'une quelconque des revendications 1 à 6, **caractérisé en ce que** le mélange gazeux est un gaz dont on cherche à contrôler la pureté, et on compare la valeur moyenne du spectre épuré correspondant au gaz à contrôler avec la valeur moyenne du spectre épuré des autres espèces gazeuses présentes dans le mélange.

11. Procédé selon l'une quelconque des revendications 1 à 6, **caractérisé en ce qu'**on sélectionne les espèces gazeuses qui sont représentatives de l'état de reconditionnement d'une chambre en cours de reconditionnement, on suit en temps réel l'évolution desdites espèces gazeuses sélectionnées dans ladite chambre en cours de reconditionnement, on compare cette évolution avec des données d'évolution de référence de reconditionnement de chambre, et on génère un signal d'alerte ou de commande lorsqu'est atteint un état des données desdites espèces gazeuses sélectionnées indiquant la fin de reconditionnement de chambre.

12. Dispositif pour la mise en oeuvre d'un procédé selon l'une quelconque des revendications 1 à 11, comprenant une source de plasma (3, 5, 6) pour générer un plasma (4) dans le mélange gazeux à étudier, des moyens (7) pour recueillir et transmettre à un spectromètre optique (8) la radiation émise par le plasma (4), un ordinateur (10) pour analyser les signaux émis par le spectromètre optique (8), l'ordinateur (10) comportant une unité centrale (11) et un programme enregistré dans une mémoire de programme (14a), ledit programme comportant la suite d'instructions mettant en oeuvre ledit procédé.

13. Dispositif selon la revendication 12, dans lequel la mémoire (14) de l'ordinateur (10) contient une zone de bibliothèque (14b) contenant les spectres optiques de référence des espèces gazeuses à analyser.
